# EUROPEAN PATENT APPLICATION

(11) **EP 1 551 066 A1**
(43) Date of publication of application: **06.07.2005**
(21) Application number: 03797648.7
(22) Date of filing: 18.09.2003
(51) Int. Cl.: H01L 51/00

(54) **MATERIAL WITH PATTERN SURFACE FOR USE AS TEMPLATE AND PROCESS FOR PRODUCING THE SAME**

(30) Priority: 19.09.2002 JP 2002273144
(71) Applicant: Daikin Industries, Ltd., Osaka-shi, Osaka 530-8323 (JP)
(72) Inventor: Morita, Masamichi, Sanda-shi, Hyogo 669-1348 (JP); Otsuka, Hideyuki, Fukuoka-shi, Fukuoka 812-0061 (JP); Takahara, Atsushi, Fukuoka-shi, Fukuoka 814-0133 (JP); Yamamoto, Ikuo, Yodogawa Works of DAIKIN IND. LTD., Settsu-shi, Osaka 566-8585 (JP); Itami, Yasuo, Yodogawa Works of DAIKIN IND. LTD., Settsu-shi, Osaka 566-8585 (JP); Aoyama, Hirokazu, Yodogawa Works, Settsu-shi, Osaka 566-8585 (JP)
(74) Representative: HOFFMANN - EITLE
(86) International application number: PCT/JP2003/011876
(87) International publication number: WO 2004/027889

(57) **Abstract**

According to the present invention, there can be obtained an anisotropic material comprising an alternating-line pattern and a layer of a functional compound formed on the surface of the alternating-line pattern, wherein one type of lines is made of a fluorine-containing compound and the other type of lines is made of a non-fluorinated compound in the alternating-line surface. When using, as a template, a pattern surface produced by using a fluorine compound having a specific structure as a surface-treating agent, a structure of a functional compound of nanometer to micrometer order can be produced by a process of applying a functional compound solution. Properties of a functional compound can be improved by using, as a template, a pattern surface, at least one region of which is surface-treated with a fluorine compound having a specific structure.

## Description

### TECHNICAL FIELD

The present invention relates to a material with a pattern surface for used as a template, and a method for producing the same.

### BACKGROUND ART

G. M. Whitesides et al. [Langmuir, 10, 1498 (1994)] showed that, when an aqueous K₃Fe(CN)₆ solution is applied on the surface of an alternating-line pattern comprising a non-fluorinated alkanethiol (hydrophobic region) and a carboxylic acid-terminated modified alkanethiol (hydrophilic region), K₃Fe(CN)₆ is crystallized on the hydrophilic region. However, there was such a problem that, when an organic solvent solution of a functional compound having low surface tension is applied on the surface of the line pattern of this combination, it is difficult to crystallize the functional compound in a line shape because the organic solvent solution spreads to wet both regions.

H. Sirringhaus et al. developed a technique wherein a partition measuring 50 nm in height and 5 µm in width made of hydrophobic polyimide is provided on a glass substrate and an aqueous conductive polymer solution is applied in the partition by an ink-jet method to form an electrically conductive polymer thin film having a width of 10 µm. However, this method had a problem that the process is complicated because the partition is provided.

JP-A-2002-261048 discloses a technique wherein a pattern surface having regions each having different affinity to a functional liquid is formed by using fluoroalkylsilane as a surface-treating agent and a functional liquid is applied to the region having high affinity by utilizing a difference in affinity. However, the fluoroalkylsilane are not described in detail in this document. Typical fluoroalkylsilane employed widely in general chemical industry is a compound having a straight-chain perfluoroalkyl group, which is represented by the formula:

CₙF₂ₙ₊₁CH₂CH₂SiCl₃ (n = 3-10)

[Langmuir, 8, 1195 (1992)] and fluoroalkylsilane having a long-chain perfluoroalkyl group (n = 8, 10) is used particularly popularly. However, the pattern surface surface-treated with the straight-chain perfluoroalkyltrichlorosilane had such a problem that a difference in the region coated selectively with the functional liquid is not clear.

JP-A-2000-307172, JP-A-7-206599 and JP-A-2001-94107 disclose techniques wherein performances of an organic semiconductor are improved by applying the organic semiconductor on a substrate surface-treated with a fluorine compound. However, there was such a problem that performances of the organic semiconductor are slightly improved.

### DISCLOSURE OF THE INVENTION

### (Technical Object to be Solved by the Invention)

An object of the present invention is to enable the production of an anisotropic material having an alternating-line pattern structure by a simple process of applying an organic solvent liquid. To achieve this object, it is necessary that a functional compound solution attains the wetting, which is faithful to an alternating-line pattern structure, on the surface of a substrate used as a template. That is, the functional compound solution spreads to wet one region of alternating lines on the substrate, and then a medium is vaporized to form a thin film of the functional compound in an alternating line shape.

Another object of the present invention is to produce a structure of a functional compound of nanometer to micrometer order by a process of applying a functional compound solution by using, as a template, a pattern surface composed of plural regions each having different surface free energy.

Still another object of the present invention is to apply a functional compound such as organic semiconductor to a pattern surface, at least one region of which is surface-treated with a fluorine compound, thereby improving properties of the functional compound.

### (Means for Solving the Problems)

In a first aspect, the present invention provides an anisotropic material comprising an alternating-line pattern and a layer of at least one functional compound selected from the group consisting of a semiconductor compound, an electrically conductive compound, a photochromic compound and a thermochromic compound, formed on the surface of the alternating-line pattern, wherein one type of lines comprises a first component comprising a fluorine-containing compound or silicone and the other type of lines comprises a second component comprising the other compound in the alternating-line pattern surface.

In a second aspect, the present invention provides a method for producing a functional material, comprising using, as a template, a pattern surface composed of plural regions each having different surface free energy, characterized in that:
(1) at least one region of the pattern surface is treated with a fluorine compound, and
(2) the method comprises applying a functional compound solution on the pattern surface and removing a solvent.

In a third aspect, the present invention provides a method for producing a functional material, which comprises applying a functional compound to a pattern surface having at least one region surface-treated with a fluorine compound.

### BRIEF DESCRIPTION OF THE DRAWINGS

Fig. 1 is a view showing a circular photomask.
Fig. 2 is a view showing a quadrangular photomask.
Fig. 3 is a view showing a triangular photomask.
Fig. 4 is a view showing a linear photomask.

### MODE FOR CARRYING OUT THE INVENTION

When a solution prepared by dissolving a functional compound such as semiconductor compound, conductive compound, photochromic compound or thermochromic compound in an organic solvent is applied on the surface of an alternating-line pattern, a thin film of the functional compound is formed in an alternating line shape and therefore an anisotropic material (that is, a functional material) can be produced.

In the alternating-line pattern surface, one type of lines are made of a first component comprising a fluorine compound or silicone and the other one type of lines are made of a second component comprising the other compound.

Examples of the base material constituting the alternating-line pattern include silicon, synthetic resin, glass, metal, and ceramics.

The synthetic resin may be either a thermoplastic resin or a thermosetting resin and examples thereof include various thermoplastic elastomers, for example, polyolefins such as polyethylene, polypropylene, ethylene-propylene copolymer, and ethylene-vinyl acetate copolymer (EVA); cyclic polyolefin, modified polyolefin, polyvinyl chloride, polyvinylidene chloride, polystyrene, polyamide, polyimide, polyamideimide, polycarbonate, poly-(4-methylpentene-1), ionomer, acrylic resin, polymethyl methacrylate, acrylic-styrene copolymer (AS resin), butadiene-styrene copolymer, polyol copolymer (EVOH), polyesters such as polyethylene terephthalate (PET), polybutylene terephthalate (PBT) and polycyclohexane terephthalate (PCT); polyether, polyether ketone (PEK), polyether ether ketone (PEEK), polyether imide, polyacetal (POM), polyphenylene oxide, modified polyphenylene oxide, polyarylate, aromatic polyester (liquid crystal polymer), polytetrafluoroethylene, polyvinylidene fluoride, fluorine resin, and various thermoplastic elastomers such as styrene polymer, polyolefin, polyvinyl chloride, polyurethane, fluororubber and chlorinated polyethylene; and epoxy resin, phenol resin, urea resin, melaimine resin, unsaturated polyester, silicone resin, polyurethane, and copolymer, polymer blend and polymer alloy composed mainly of these. One or more kinds of them can be used in combination (for example, as at least two-layered laminate).

Examples of the glass include silica glass (quartz glass), alkali-silicate glass, soda-lime glass, potash-lime glass, lead (alkali) glass, barium glass, and borosilicate glass.

Examples of the metal include gold, silver, copper, iron, nickel, aluminum, and platinum.

Examples of the ceramic include oxides (for example, aluminum oxide, zinc oxide, titanium oxide, silicon oxide, zirconia, and barium titanate), nitrides (for example, silicon nitride and boron nitride), sulfides (for example, cadmium sulfide), and carbides (for example, silicon carbide), and a mixture thereof may be used.

Even when any substrate is used, a functional group may be introduced into the surface of the substrate by plasma treatment or UV treatment.

The compound used to form the alternating-line pattern on the surface of the base material may be an organic silane compound, an organic thiol compound, an organic disulfide compound, or an organic phosphate ester compound. That is, lines made of a fluorine-containing compound or silicone and lines made of the other compound can be formed from an organic silane compound, an organic thiol compound, an organic disulfide compound, or an organic phosphate ester compound.

A difference between surface free energy of lines made of a fluorine-containing compound or silicone and surface free energy of lines made of the other compound is preferably at least 5 mJ/m², for example, at least 10 mJ/m², particularly at least 20 mJ/m².

The line width of the alternating-line pattern may be from 0.5 µm to 100 µm, for example, from 1 µm to 20 µm. The line width may be constant or changed. The shape of lines may be either a straight line or a curved line.

The functional compound solution may be allowed to move spontaneously along lines by providing lines having lower surface free energy with tilt of surface free energy. Tilt of surface free energy can be provided, for example, by the method of M. K. Chaudhury et al. [Science, 256, 1539 (1992)].

Regarding unevenness of alternating lines, when the region having affinity with the functional compound is indented to form a groove, it is easy to wet in a line shape, as a matter of course. However, according to the present invention, it becomes possible to wet in a line shape by only a difference in surface free energy without providing unevenness intentionally. In case of preparing a pattern surface with only a monomolecular film, unevenness is not more than 10 nm, and preferably not more than 2 nm. The unevenness can be substantially neglected as compared with a line width of micron order. In the present invention, regardless of such a smooth surface, a solution of a functional compound spreads to wet one region of alternating lines, as if the groove existed.

In the present invention, the shape of droplets is preferably distorted longitudinally in a line direction when 2 µL of ethanol is gently dropped on a line pattern surface serving as a template used to prepare an anisotropic material. The degree of distortion is preferably at least 1.1, for example, at least 1.2, in terms of a ratio L/W of the length in a major axis (L) to the length in a minor axis (W) of droplets. When this condition is satisfied, the organic solvent remarkably tends to spread to wet one region of alternating lines on the alternating-line pattern surface.

Both lines of the alternating-line pattern surface used as a template may be made of a monomolecular film or not.

The alternating-line pattern surface of the present invention is prepared by the method such as photolithography, microcontact printing, self-assembling method, or electron beam irradiation method, and the method is not specifically limited. For example, Sugimura et al. [Langmuir, 16, 885 (2000)] reported that, when an organic silane monomolecular film formed on a silicon wafer as a substrate is irradiated with vacuum-ultraviolet light through a line-shaped photomask, the irradiated area is photodecomposed to form a silanol group, thus obtaining a line pattern surface in which organic silane regions and silanol group regions are alternately arranged. Furthermore, when another organic silane is chemically adsorbed on this surface, it selectively reacts with the silanol group region to give a composite monomolecular film (photolithography method). G. M. Whitesides et al. [Langmuir, 10, 1498 (1994)] reported that a line pattern surface can be prepared by applying alkanethiol as an ink to a silicone stamp and stamping on a gold substrate (microcontact printing method). M. Gleiche et al ["Nanoscopic channel lattices with controlled anisotropic wetting", NATURE, 403, 13 (2000)] reported that, when dipalmitoyl phosphatidylcholine (DPPC) as a hydrocarbon amphiphile spread over the water surface is transferred on a mica substrate under specific conditions, there can be obtained a line pattern surface in which DPPC and mica are alternately arranged in a self-assembling manner.

The alternating-line pattern is made of a first component and a second component.

The first component is a fluorine-containing compound or silicone. The second component is a compound other than the fluorine-containing compound and silicone.

Examples of the fluorine-containing compound include a fluorine-containing organic silane compound, a fluorine-containing organic thiol compound, a fluorine-containing organic disulfide compound, and a fluorine-containing organic phosphate ester compound.

Examples of the fluorine-containing group in the fluorine-containing compound include a fluoroalkyl group (particularly, a perfluoroalkyl group), and a perfluoropolyether group. The number of carbon atoms of the fluorine-containing group is normally form 1 to 20, for example, 1 to 10.

Examples of the silicone include dimethylpolysiloxane, methylphenylpolysiloxane, methylhydrogenpolysiloxane, and silicone resin, and these silicones may be modified with fluorine.

The compound (the second component) other than the fluorine compound and silicone may be an organic silane compound, an organic thiol compound, an organic disulfide compound, and/or an organic phosphate ester compound, which is not fluorinated or siliconated. The other compound may be a compound which has neither a fluorine atom nor a SiO bond.

On a line pattern surface, a layer of a functional compound is formed. The functional compound is a semiconductor compound, an electrically conductive compound, a photochromic compound, and/or a thermochromic compound.

The functional compound used in the present invention is at least one selected from the group consisting of the semiconductor compound, the conductive compound, the photochromic compound and the thermochromic compound.

The semiconductor compound is preferably an organic compound and examples thereof include a pentacene derivative, a polythiophene derivative, a phthalocyanine derivative, a polyfluorene derivative, poly(p-phenylenevinylene), and a layered perovskite compound.

The conductive compound has conductivity of at least 10² S/cm at room temperature and is preferably an organic compound, and examples thereof include a polyacetylene derivative, a polythiophene derivative, polypyrrole, poly(p-phenylenevinylene), and polyaniline. The conductivity may be improved by doping these compounds.

The photochromic compound is preferably an organic compound and examples thereof include an azobenzene derivative, a spiropyran derivative, a fulgide derivative, and a diarylethene derivative.

The thermochromic compound is a generic term of a compound wherein a color of a substance varies reversibly with a change in temperature, and examples thereof include salicylideneanilines, a polythiophene derivative, a tetrahalogeno complex, an ethylenediamine derivative complex, a dinitrodiammine-copper complex, a 1,4-ziazacyclooctane (daco) complex, a hexamethylenetetramine (hmta) complex, and a salicylaldehyde (salen) complex.

The thickness of a layer of the functional compound may be from 0.1 nm to 100 µm, for example, from 1 nm to 1 µm.

The layer of the functional compound can be formed by applying a solution prepared by dissolving the functional compound in a solvent on the surface of a line pattern and removing the solvent. Examples of the solvent include an organic solvent and water. In case that the functional compound is slightly soluble in water, it must be dissolved in the organic solvent.

In the present invention, the solvent used to dissolve the functional compound is preferably a solvent having a surface tension of not more than 30 mN/m, for example, not more than 20 mN/m. When the surface tension is not more than 30 mN/m, the solution easily spreads to wet along lines.

Examples of the organic solvent include alcohols, esters, ketones, ethers, and hydrocarbons (for example, aliphatic hydrocarbons and aromatic hydrocarbons) and the organic solvent may be fluorinated or not. Specific examples of the organic solvent include methanol, ethanol, isopropanol, perfluorodecalin, hydrofluoroether, HCFC225, chloroform, 1,1,2,2-tetrachloroethane, tetrachloroethylene, chlorobenzene, ethyl acetate, butyl acetate, acetone, hexane, isopentane, toluene, xylene, and tetrahydrofuran.

The concentration of the functional compound in the solution may be from 0.1 to 20% by weight, for example, from 1 to 10% by weight.

The solvent can be removed by vaporization. The solvent can be removed by heating an anisotropic material, for example, to a temperature of 60 to 200°C. The solvent may be removed under reduced pressure (for example, 0.01 to 100 Pa).

In the present invention, examples of the method of applying the functional compound solution include a spin coating method, a dip coating method, a casting method, a roll coating method, a printing method, a transfer method, an ink-jet printing method [P. Calvert, Chem. Mater., 13, 3299 (2001)], a bar coating method, and a capillary method.

The anisotropic material (that is, the functional material) of the present invention can be used as an electronic device in transistors, memories, light emitting diodes (EL), lasers and solar batteries, and is also used as an optical device in optical memories, image memories, light modulation elements, optical shutters, secondary harmonic (SHG) devices and polarizers.

In the second aspect of the present invention, it has been found that a functional material is produced by a method wherein a pattern surface prepared by using the fluorine compound as a surface-treating agent is used as a template and a functional compound solution is applied, and then a solvent is removed. Thus, a functional material as a structure of a functional compound of nanometer to micrometer order, for example, size of about 10 nm to 100 µm (for example, width (particularly, maximum width or minimum width) or diameter) is obtained.

In this second aspect, descriptions are the same as those in the first aspect, except that the pattern shape is not limited to line, the functional compound is not limited to a semiconductor compound, an electrically conductive compound, a photochromic compound or a thermochromic compound, and a fluorine compound is used to prepare a pattern surface.

The shape of the pattern surface may be selected according to the purposes of the finally produced device. Examples of the shape include circle, quadrangle, triangle, straight line, and curved line. Patterns may be contacted or separated with each other. The pattern surface is characterized by comprising at least two kinds of regions each having different surface free energy, at least one region being surface-treated with a fluorine compound.

Examples of the functional compound include a semiconductor compound, a conductive compound, a photochromic compound, a thermochromic compound, a magnetic compound, and a bioactive compound.

The fluorine compound used to prepare a pattern surface is preferably a fluorine compound having the following structures:
(a) a fluorine compound which has a branched fluoroalkyl group having 5 or less carbon atoms,
(b) a fluorine compound having a perfluoropolyether group,
(c) a fluorine compound having a polymer structure obtained by polymerizing a monomer which has a fluoroalkyl group having 5 or less carbon atoms,
(d) a fluorine compound having a linking group which is any one of an urethane group, an ester group, an ether group and an amide group, existing between a fluoroalkyl group having 5 or less carbon atoms and a functional group,
(e) an incompletely-condensed silsesquioxane which has a fluoroalkyl group having 5 or less carbon atoms, and/or
(f) a completely-condensed silsesquioxane which has a silane group and a fluoroalkyl group having 5 or less carbon atoms.

The fluoroalkyl group in the fluorine compound may be a perfluoroalkyl group (having 1 to 5 carbon atoms).

Examples of the fluorine compound include a fluorine-containing organic silane compound, a fluorine-containing organic thiol compound, a fluorine-containing organic disulfide compound, and a fluorine-containing organic phosphate ester compound.

The fluorine compound has a functional group, for example, a silane group (-SX₃ (wherein X is a hydrogen atom, a halogen atom or an oxyalkyl group (having 1 to 4 carbon atoms))), a thiol group (-SH), a disulfide group (-S-S-), or a phosphoric acid group (P(=O)(OH)₃₋ₙ(O-)ₙ) (provided that n is 1 to 3).

In the fluorine compound (a) which has a branched fluoroalkyl group having 5 or less carbon atoms, examples of the branched fluoroalkyl group include (CF₃)₂CF-, (CF₃)₃C-, (CF₃)₂CFCF₂CF₂-, and (CF₃)₃CCF₂-. The fluorine compound (a) is a compound having a branched fluoroalkyl group and a functional group (for example, a silane group).

Examples of the fluorine compound (a) include the followings:

(CF₃)₃C-A-SiX₃,

(CF₃)₃C-A-SH,

(CF₃)₂CFCF₂CF₂-A-SiX₃,

(CF₃)₂CFCF₂CF₂-A-SH,

(CF₃)₂CFO-A-SiX₃,

and

(CF₃)₂CFO-A-SH

wherein A is an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) or a -CH₂CH(OH)CH₂- group, and X is a halogen atom (for example, a chlorine atom), or OCₙH₂ₙ₊₁(n=1 to 4).

Specific examples thereof include the followings:

(CF₃)₃C-CH₂CH₂-SiCl₃,

(CF₃)₃C-SO₂N(C₂H₅)CH₂CH₂-SiCl₃,

(CF₃)₃C-CH₂CH₂-SH,

(CF₃)₂CFCF₂CF₂-CH₂CH₂-Si(OCH₃)₃,

(CF₃)₂CFCF₂CF₂-CH₂CH₂-SH,

(CF₃)₂CFO-CH₂CH₂-Si(OCH₃)₃,

and

(CF₃)₂CFO-CH₂CH₂-SH.

In the fluorine compound (b) having a perfluoropolyether group, examples of the perfluoropolyether group include the following:

CₐF₂ₐ₊₁O(CF₂CF₂CF₂O)ₘ(CF₂)₁-,

CₐF₂ₐ₊₁O(CF₂CF(CF₃)O)ₘ(CF₂)₁-,

CₐF₂ₐ₊₁O(CF₂CF₂CF₂O)ₘ(CF₂O)ₙ(CF₂)₁-,

and

CₐF₂ₐ₊₁O(CF₂CF(CF₃)O)ₘ(CF₂O)ₙ(CF₂)₁-

wherein a molecular weight of a perfluoropolyether group is at least 300, preferably at least 500, and not more than 100000, for example, not more than 5000, m and n represent 1 to 100, and preferably 20 to 40, a represents 1 to 10, and 1 represents 1 or 2. The fluorine compound (b) is a compound having a perfluoropolyether group and a functional group (for example, a silane group).

Examples of the fluorine compound (b) include the followings:

PFPE-A-SiX₃,

and

PFPE-A-SH

wherein PFPE is a perfluoropolyether group, A is an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) or a -CH₂CH(OH)CH₂- group, and X is a halogen atom (for example, chlorine atom), or OCₙH₂ₙ₊₁ (n=1 to 4).

Specific examples thereof include the followings:

PFPE-CH₂CH₂-Si(OCH₃)₃,

PFPE-SO₂N(C₂H₅)CH₂CH₂-Si(OCH₃)₃,

and

PFPE-CH₂CH₂-SH.

In the fluorine compound (c) having a polymer structure obtained by polymerizing a monomer which has a fluoroalkyl group having 5 or less carbon atoms, examples of the fluoroalkyl group having 5 or less carbon atoms include CF₃-, CF₃CF₂-, CF₃CF₂CF₂-, (CF₃)₂CF-, CF₃CF₂CF₂CF₂-, (CF₃)₂CFCF₂-, (CF₃)₃C-, CF₃CF₂CF₂CF₂CF₂-, (CF₃)₂CFCF₂CF₂-, and (CF₃)₃CCF₂-. The monomer having a fluoroalkyl group is a compound having a fluoroalkyl group and a carbon-carbon double bond. The monomer having a fluoroalkyl group may be a fluoroalkyl group-containing vinyl monomer.

The fluoroalkyl group-containing vinyl monomer may be a (meth)acrylate having a fluoroalkyl group, or an acrylate in which hydrogen at the α-position having a fluoroalkyl group is substituted with a halogen atom, CF₃, CF₂H or CFH₂.

The fluoroalkyl group-containing acrylate may be represented by the following general formula:

Rf-A-OC(=O)CR³=CH₂

wherein Rf is a straight-chain or branched fluoroalkyl group having 1 to 5 carbon atoms, R³ is a hydrogen atom, an F atom, a Cl atom, a CF₃ group, a CF₂H group, a CFH₂ group or a methyl group, and A is a divalent organic group.

Examples of A include an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) and a -CH₂CH(OH)CH₂- group.

Examples of the fluoroalkyl group-containing acrylate include the followings:

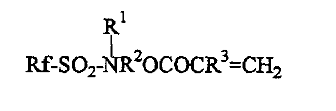

Rf-(CH₂)ₙOCOCR³=CH₂

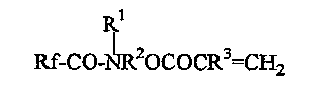

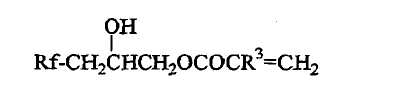

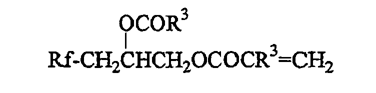

Rf-O-Ar-CH₂OCOCR³=CH₂

wherein Rf is a fluoroalkyl group having 1 to 5 carbon atoms, R¹ is a hydrogen or an alkyl group having 1 to 10 carbon atoms, R² is an alkylene group having 1 to 10 carbon atoms,
R³ is a hydrogen atom, an F atom, a Cl atom, a CF₃ group, a CF₂H group, a CFH₂ group or a methyl group, Ar is an arylene group which may have a substituent, and n is an integer of 1 to 10.

Examples of the polymer structure obtained by polymerizing a monomer which has a fluoroalkyl group having 5 or less carbon atoms include the followings:

- (Rf-A-OCOCR³CH₂)ₙ-

wherein Rf, A and R³ are as defined above, and n is from 1 to 200, and particularly from 2 to 100.

Examples of the fluorine compound (c) include the followings:
Polymer-D-SiX₃, and
Polymer-D-SH
wherein Polymer represents a polymer structure group obtained by polymerizing a monomer which has a fluoroalkyl group having 5 or less carbon atoms, D represents a divalent group obtained by linking S and an urethane group interposed between two alkylene groups having 1 to 4 carbon atoms, for example, -S(CH₂)₂OCONH(CH₂)₃-, and X represents a halogen atom (for example, a chlorine atom), or OCₙH₂ₙ₊₁ (n=1 to 4).

Specific examples thereof include the followings:

H(Rf-A-OCOCHCH₂)₄-CH₂CH₂-Si(OCH₃)₃,

H(Rf-A-OCOCHCHCl)₄-CH₂CH₂-Si(OCH₃)₃,

H(Rf-A-OCOCHCHF)₄-CH₂CH₂-SiCl₃,

H(Rf-A-OCOCClCH₂)₄-CH₂CH₂-Si(OCH₃)₃,

and

H(Rf-A-OCOCFCH₂)₄-CH₂CH₂-SiCl₃.

In the fluorine compound (d) having a linking group which is any one of an urethane group, an ester group, an ether group and an amide group, existing between a fluoroalkyl group having 5 or less carbon atoms and a functional group, examples of the fluoroalkyl group having 5 or less carbon atoms are the same as those in the fluorine compound (c).

Examples of the fluorine compound (d) include the followings:

Rf-A-OCONH-A'-SiX₃,

Rf-A-OCONH-A'-SH,

Rf-A-NHCOO-A'-SiX₃,

Rf-A-NHCOO-A'-SH,

Rf-A-OCO-A'-SiX₃,

Rf-A-OCO-A'-SH,

Rf-A-COO-A'-SiX₃,

Rf-A-COO-A'-SH,

Rf-A-O-A'-SiX₃,

Rf-A-O-A'-SH,

Rf-A-CONH-A'-SiX₃,

Rf-A-CONH-A'-SH,

and

Rf-A-NHCO-A'-SH.

wherein Rf represents a fluoroalkyl group having 5 or less carbon atoms, A and A' represent an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) or a - CH₂CH(OH)CH₂- group, and X is a halogen atom (for example, chlorine atom), or OCₙH₂ₙ₊₁ (n=1 to 4) .

Examples thereof include the followings:

Rf-CH₂CH₂-OCONH-CH₂CH₂CH₂- (OCH₃)₃,

Rf-CH₂CH₂-OCONH-CH₂CH₂CH₂-SH,

Rf-CH₂CH₂-NHCOO-CH₂CH₂CH₂-(OCH₃)₃,

Rf-CH₂CH₂-NBCOO-CH₂CH₂CH₂-SH,

Rf-CH₂CH₂-OCO-CH₂CH₂CH₂-SiCl₃,

Rf-CH₂CH₂-OCO-CH₂CH₂CH₂-SH,

Rf-CH₂CH₂-COO-CH₂CH₂CH₂- (OCH₃)₃,

Rf-CH₂CH₂-COO-CH₂CH₂CH₂-SH,

Rf-CH₂CH₂-O-CH₂CH₂CH₂-SiCl₃,

Rf-CH₂CH₂-O-CH₂CH₂CH₂-SH,

Rf-CH₂CH₂-CONH-CH₂CH₂CH₂-SiCl₃,

Rf-CH₂CH₂-CONH-CH₂CH₂CH₂-SH,

Rf-CH₂CH₂-NHCO-CH₂CH₂CH₂-SiCl₃,

and

Rf-CH₂CH₂-NHCO-CH₂CH₂CH₂-SH.

In the incompletely-condensed silsesquioxane (e) which has a fluoroalkyl group having 5 or less carbon atoms, examples of the fluoroalkyl group having 5 or less carbon atoms are the same as those in the fluorine compound (c). The incompletely-condensed silsesquioxane (e) may be represented by the general formula:

[R-Si (OH) O_{2/2}]ₗ[R'-SiO_{3/2}]ₘ

wherein R and R' represent Rf, Rf-A, an alkyl group (having 1 to 22 carbon atoms), or a derivative of an alkyl group (having 1 to 22 carbon atoms) (provided that at least one of R and R' is Rf or Rf-A) (wherein Rf represents a fluoroalkyl group having 5 or less carbon atoms, and A represents an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) or a -CH₂CH(OH)CH₂- group), and 1 and m represent such a number that a molecular weight of the incompletely-condensed silsesquioxane is within a range from 500 to 100000. The silsesquioxane is also referred to as POSS (Polyhedral Oligomeric Silsesquioxane). A silanol group of the incompletely-condensed silsesquioxane has high reactivity and is therefore linked strongly with an active OH group of the substrate. The number of the silanol group in the molecule is from 1 to 3. 1 is normally from 1 to 3. m is normally at least 1, for example, at least 2, and particularly at least 3.

Specific examples of the incompletely-condensed silsesquioxane (e) include: 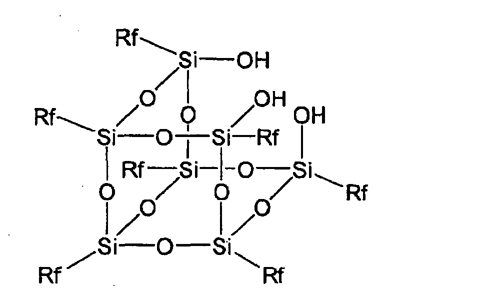 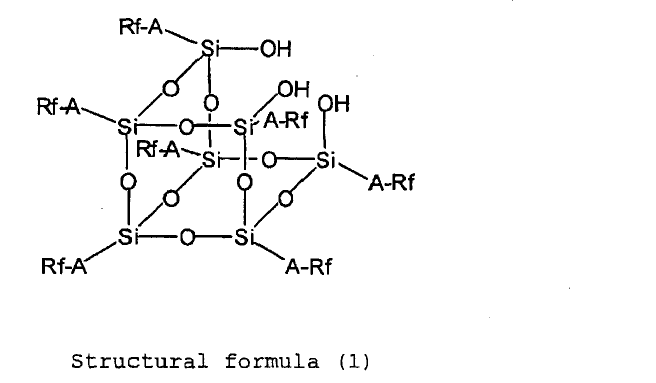 and POSS Silanols 54,456-6 manufactured by Aldrich Co.

In the completely-condensed silsesquioxane (f) which has a silane group and a fluoroalkyl group having 5 or less carbon atoms, the silane group is a -SX₃ group (X is a halogen atom (for example, a chlorine atom), or OCₙH₂ₙ₊₁ (n=1 to 4)). Examples of the fluoroalkyl group having 5 or less carbon atoms are the same as those in the fluorine compound (c).

The completely-condensed silsesquioxane (f) may be represented by the formula:

[R-SiO_{3/2}]ₗ[R'-SiO_{3/2}]ₘ

wherein R represents Rf, Rf-A, an alkyl group (having 1 to 22 carbon atoms), or a derivative of an alkyl group (having 1 to 22 carbon atoms) (provided that at least one of R is Rf or Rf-A) (wherein Rf represents a fluoroalkyl group having 5 or less carbon atoms, A represents an alkylene group having 1 to 4 carbon atoms, a -SO₂N(R²¹)R²²- group (provided that R²¹ is an alkyl group having 1 to 4 carbon atoms, and R²² is an alkylene group having 1 to 4 carbon atoms) or a - CH₂CH(OH)CH₂- group), R' represents an organic group containing SiX₃, for example, -(CH₂)ₙSiX₃ (n is from 1 to 10), and 1 and m represent such a number that a molecular weight of the completely-condensed silsesquioxane is within a range from 500 to 100000.

1 and m are normally at least 1.

The completely-condensed silsesquioxane (f) can be obtained by condensing an incompletely-condensed silsesquioxane (e) with bis-silane. Examples of the bis-silane include the followings:
bis-(triethoxysilyl)ethane,
bis-(triethoxysilylpropyl)amine, and
bis-(trimethoxysilylpropyl)tetrasulfide.

Specific examples of the completely-condensed silsesquioxane (f) include the following: 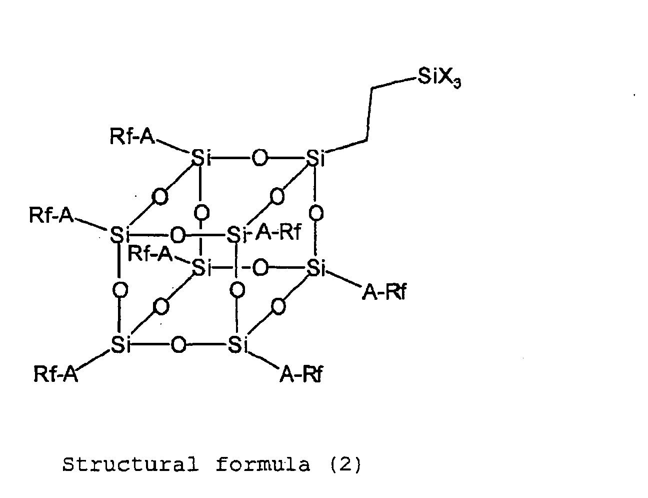 wherein X is a halogen atom (for example, a chlorine atom), or OCₙH₂ₙ₊₁(n=1 to 4).

In the third aspect of the present invention, a functional material is obtained by using, as a template, a pattern surface, at least one region of which is surface-treated with a fluorine compound, and applying a functional compound such as organic semiconductor on the template. Thus, properties of the functional compound can be improved.

In the third aspect, explanations are the same as those recited in the second aspect, except that the method of applying the functional compound to the pattern surface is not limited to an application treatment.

The method of applying the functional compound to the pattern surface is not specifically limited as far as it is a method of contacting the functional compound with the pattern surface, and a method capable of improving properties of the functional compound as highly as possible may be appropriately selected regardless of solid phase, liquid phase or vapor phase. Examples of the application method include a friction transfer method, a spin coating method, a casting method, an ink-jet method, a dipping method, a vacuum deposition method, and a sputtering method.

Even if the functional compound is applied on the whole surface of the pattern surface, a difference in structure of a thin film made of the functional compound arises in the region surface-treated with the fluorine compound and the other region, and thus properties of the functional compound can be maximized.

### PREFERRED EMBODIMENTS

The present invention will now be described by way of examples, but is not limited to the following examples.

### 1. Test Example in which a fluorine compound is used for one alternating-line pattern surface

### • Preparation of alternating-line pattern surface

After a silicon wafer is washed with acetone, the surface is terminated with a hydroxyl group by heating in hydrogen peroxide water/concentrated sulfuric acid = 3/7 (volume ratio) at 110°C for one hour. An organic silane as a first component is chemically adsorbed on the silicon wafer. When the silicon wafer is irradiated with vacuum-ultraviolet light (172 nm) through a line-shaped photomask (line width: 0.1 µm, 1 µm, 5 µm, and 10 µm), the irradiated organic area is photodecomposed to form a silanol group, thus obtaining a line pattern surface in which organic silane regions and silanol group regions are alternately arrayed. When another organic silane as a second component is chemically adsorbed on the surface, it selectively reacts with the silanol group region to give a composite monomolecular film. According to the above method, pattern surfaces having various combinations of a fluoroalkyl group (C₆F₁₃), an alkyl group (C₁₀H₂₁ and C₁₈H₃₇), a silanol group (SiOH) and a sulfonic acid group (SO₃H) were prepared.

Hereinafter, the respective surfaces are abbreviated as follows: C₆F₁₃ → Rf, C₁₀H₂₁ → Rh(C₁₀) and C₁₈H₃₇ → Rh(C₁₈), and SiOH and SO₃H are used without being abbreviated.

Reagents used to prepare the respective surfaces are as follows: Rf is perfluorohexylethyltrimethoxysilane (manufactured by Fluorochem Ltd.), Rh(C₁₈) is n-octadecyltrimethoxysilane (manufactured by CHISSO CORPORATION), and Rh(C₁₀) is n-decyltriethoxysilane (manufactured by CHISSO CORPORATION). In case of SO₃H, γ-mercaptopropyltrimethoxysilane (manufactured by CHISSO CORPORATION) was chemically adsorbed, irradiated with UV light (254 nm) for 10 hours, thereby converting a terminal SH group into a sulfonic acid group due to photooxidation.

Formation of the objective pattern was confirmed by a lateral force microscope.

### • Method for measurement of surface free energy of sole monomolecular film

Surface free energy of a sole monomolecular film, which is not a patterning surface, was determined by substitution of a contact angle of water and methylene iodide into the formula of D. K. Owens [J. Applied Polym. Sci., 13, 1741 (1969)] (Table 1).

**Table 1:**

| Contact angle and surface free energy on various sole monomolecular films | | | | | | |
|---|---|---|---|---|---|---|
| Monomolecular film | Water | Methylene iodide | Surface free energy (water-methylene iodide) | | | |
| | | | γd | γP | γ | Difference from Rf |
| SiOH | 0 | 0 | 38.8 | 37.5 | 76.3 | 62 |
| SO₃H | 40 | 42 | 29.5 | 29.9 | 59.4 | 45 |
| Rh(C18) | 103 | 61 | 28.3 | 0.2 | 28.5 | 14 |
| Rh(C10) | 97 | 68 | 22.4 | 2.0 | 24.4 | 10 |
| Rf | 106 | 88 | 12.3 | 1.9 | 14.2 | - |

### • Pattern surface prepared

Pattern surfaces shown in Table 2 were prepared. In the column of "combination of patterns", "first component/second component" was described. "Difference in surface free energy" is a difference in surface free energy of a sole monomolecular film determined in Table 1. "Line width" was measured by a lateral force microscope. "Unevenness of alternating lines" denotes a difference between a molecular length of the first component and a molecular length of the second component, and was measured by an atomic force microscope. Regarding "L/S of ethanol droplets (2 µL)", the degree of distortion, when 2 µL of ethanol is gently dropped from above the pattern surface, is expressed by a ratio L/W of the length in a major axis (L) to the length in a minor axis (W) of droplets. "Wetting of n-hexadecane in alternating line shape" was observed by an optical microscope after spin coating with a 1 % ethanol solution (2000 rpm). The case in which regions where n-hexadecane spreads to wet in a line shape and regions where no line exists are alternately formed was rated "Good", while the case where n-hexadecane spreads to wet in an indeterminate form was rated "Poor".

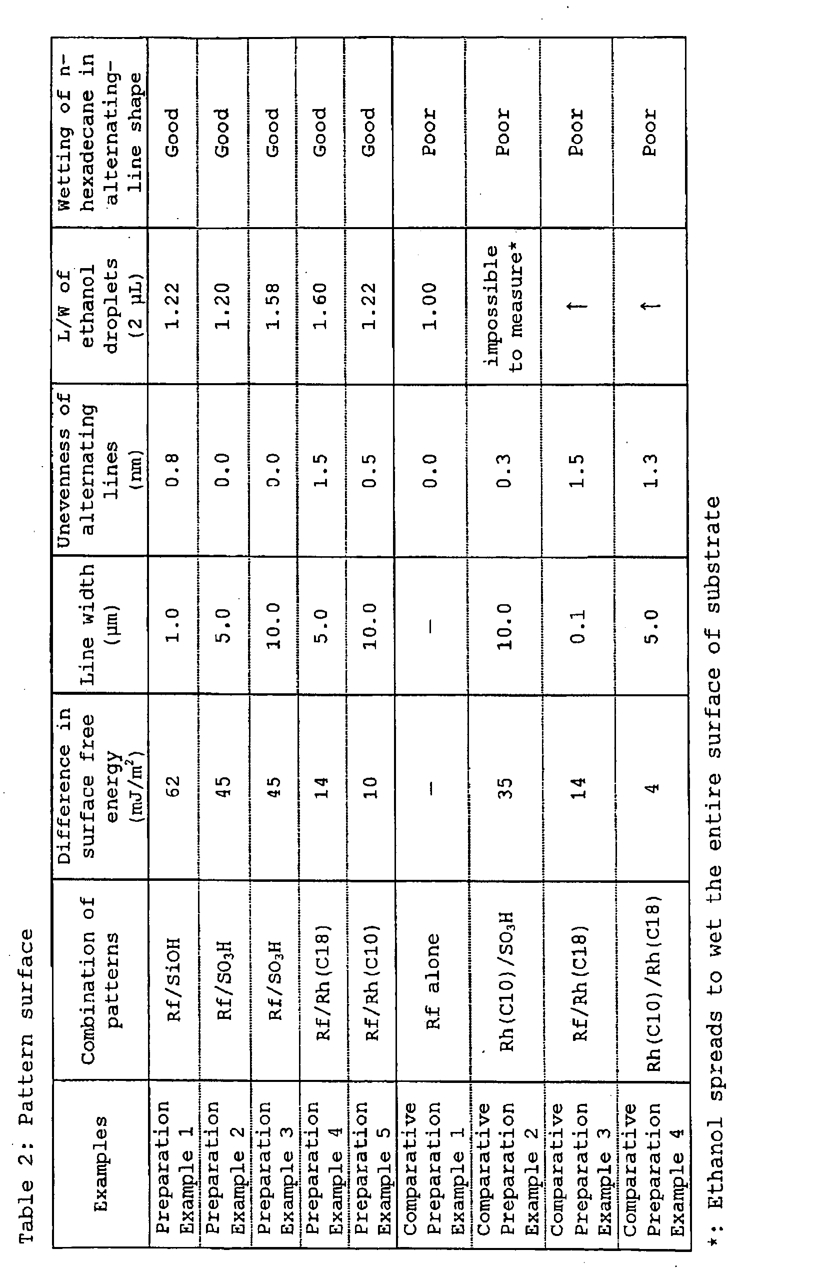

### Examples 1 to 5 and Comparative Examples 1 to 4

Using each pattern surface shown in Table 2 as a template, a 1 wt% functional compound solution shown in Table 3 was applied thereon. The spin coating was performed at 2000 rpm, and the dip coating was performed by fixing a substrate in a direction in which lines of a pattern are vertical to the solution surface, and the dipping and pull-up operations were performed at a rate of 1 mm/second.

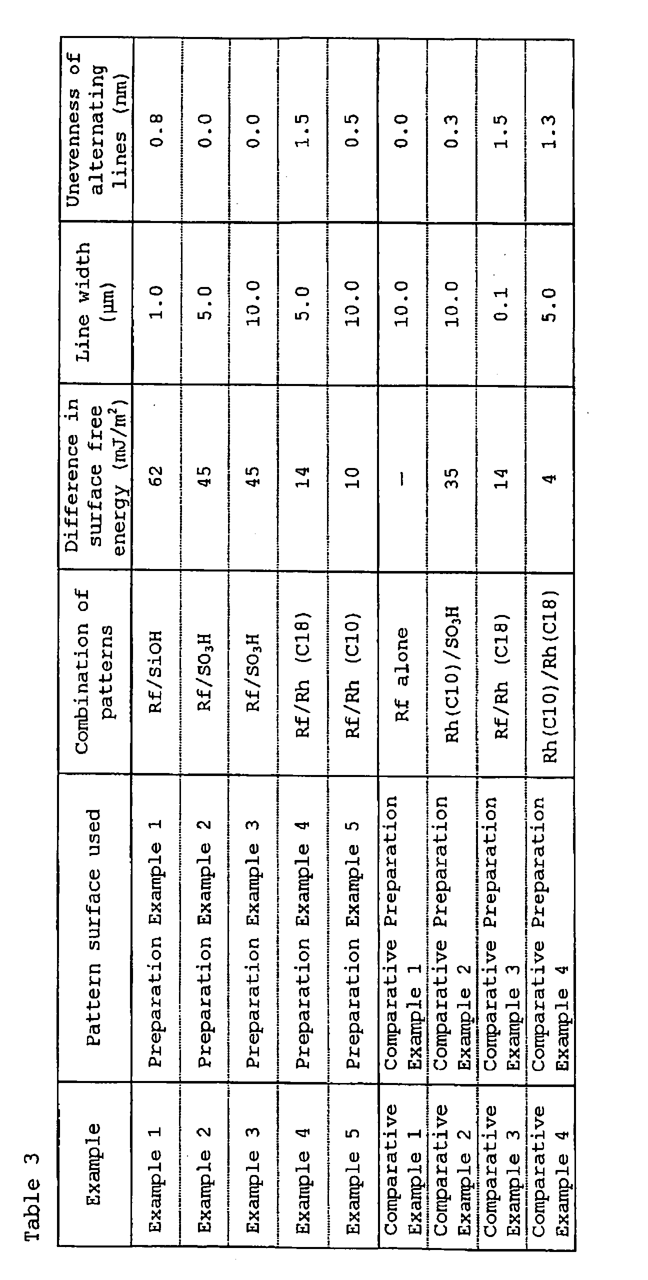

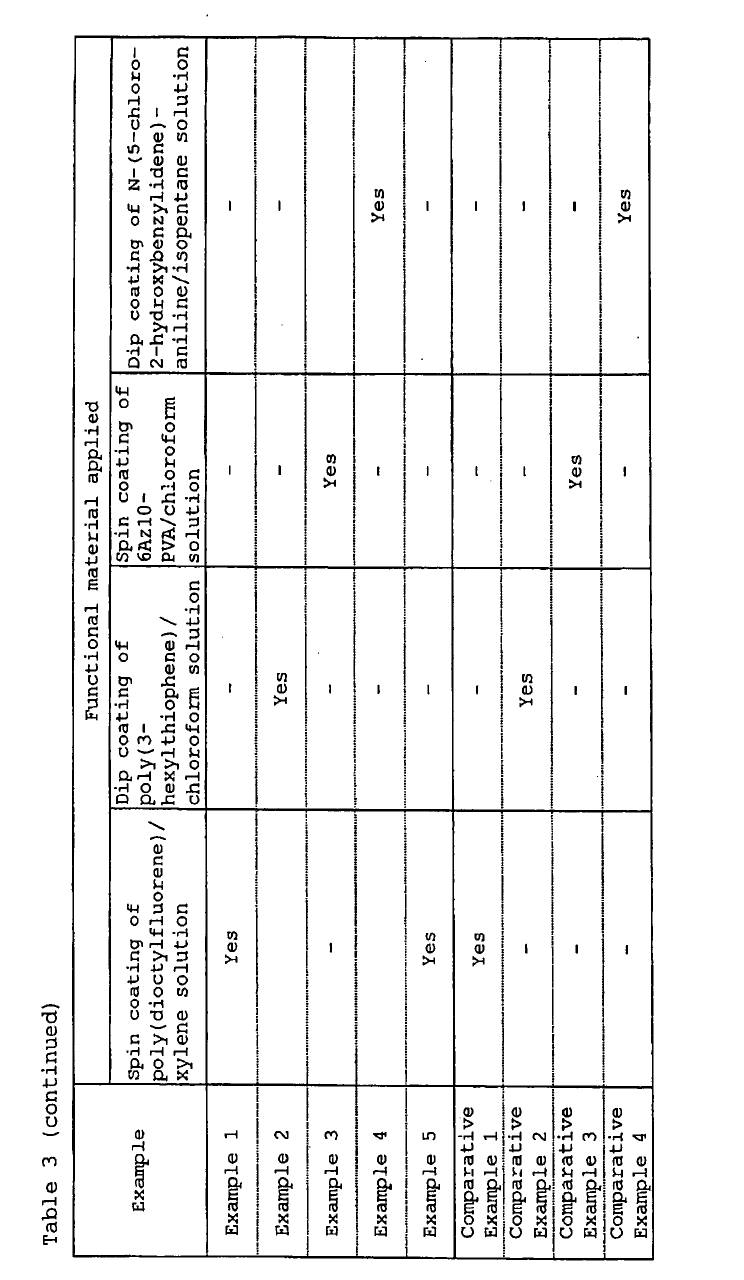

Functional materials shown in Table 3 are as follows.
Poly(dioctylfluorene): ADS129BE, manufactured by American Dye Source, Inc.
Poly(3-hexylthiophene): manufactured by Rieke Metals Co. (Aldrich Product No. 44570-3), head-to-tail regiospecific: at least 98.5%
6Az10-PVA: which has the following structure in which azobenzene is introduced into a polyvinyl alcohol side chain, and synthesized by the method of T. Seki et al. [J. Phys. Chem. B, 103, 10338 (1999)] 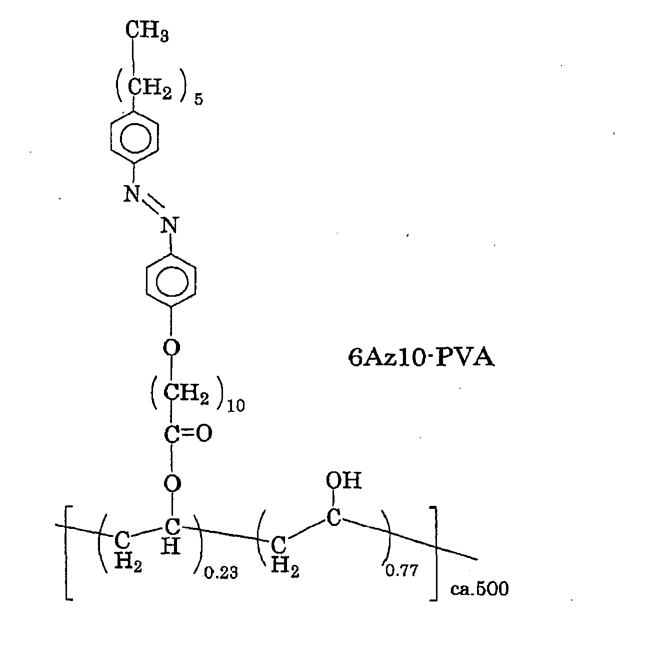
N-(5-chloro-2-hydroxybenzylidene)-aniline: which is synthesized by the method of Konawa at al. [J. Am. Chem. Soc., 120, 7107 (1998)]

In Examples 1 to 5 according to the present invention, it was confirmed by an optical microscope and an atomic force microscope that a thin film (120 nm thick) of a functional compound is formed in an alternating line shape on the pattern surface used as the template. In Comparative Examples 1 to 4, a uniform thin film (140 nm thick) of a functional compound was formed on the entire surface of the substrate without constituting a line.

### 2. Test Example in which silicone is used for one alternating-line pattern surface

### Preparation Example 6 and Example 6

A stamp having a line width of 5 µm, the surface of which is coated by the method of T. Deng et al. [Langmuir, 18, 6720(2002)], was prepared. A 0.5 wt% dimethylpolysiloxane (100 cSt)/toluene solution was applied to the stamp and then applied on a glass substrate. Formation of an alternating-line pattern was confirmed by an atomic force microscope. As a result, it has been found that a dimethylpolysiloxane thin film having a width of 5 µm is formed and the thickness of the film is 50 nm. On the pattern surface, a 1% aqueous solution of sodium poly[2-(3-thienyl)ethyloxy-4-butylsulfonate] (ADS2000P, manufactured by American Dye Source, Inc.) was spin-coated (2000 rpm). It was confirmed by a fluorescence microscope and an atomic force microscope that a thin film (170 nm thick) of ADS2000P is formed on the pattern surface in an alternating line shape.

### 3. Test Example in which a fluorine compound having a specific structure is used for one pattern surface with various shapes

### Preparation Examples 7 to 17 and Comparative Preparation

### Example 5

On the same silicon wafer as in Preparation Example 1, a fluorine organic silane shown in Table 4 was chemically adsorbed in a liquid phase by the following method. The organic silane was diluted with a soluble dehydrated organic solvent, and then a silicon wafer was dipped in the resulting 1 wt% solution for one hour. After dipping, the silicon wafer was washed with the same organic solvent and dried in an atmospheric air to prepare a sole monomolecular film of the fluorine organic silane alone. A contact angle and surface free energy of the sole monomolecular film, which is not a pattern surface, were also shown in Table 4.

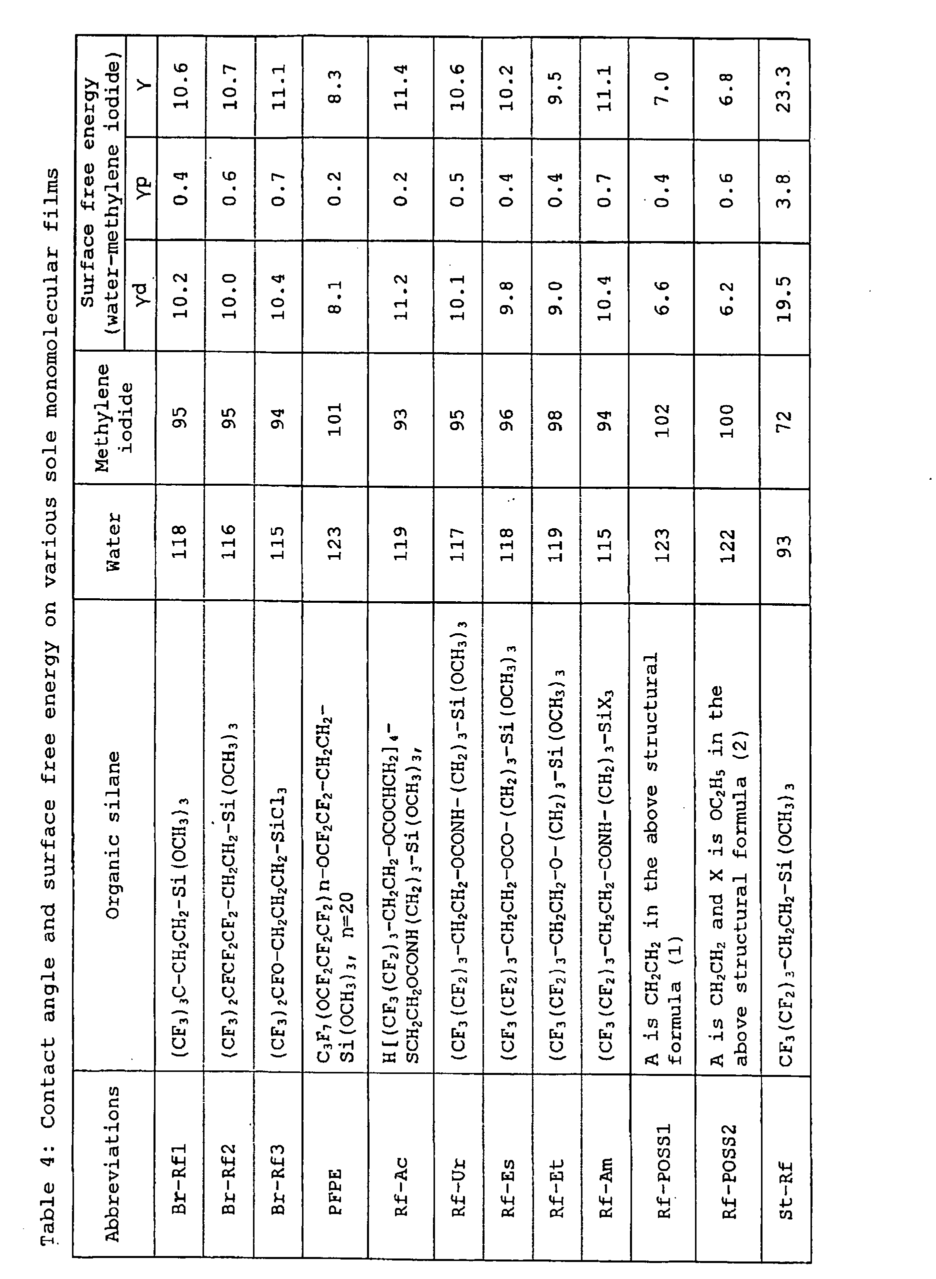

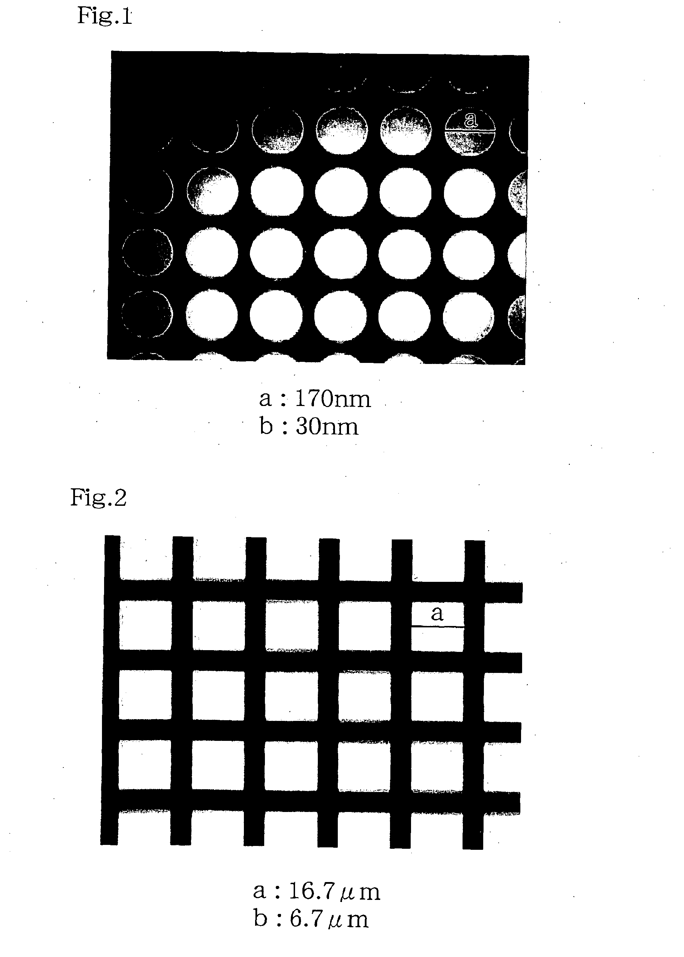

Then, the resulting sole monomolecular film was irradiated with vacuum-ultraviolet light (wavelength: 172 nm) through a photomask having each shape shown in Figs. 1 to 4 (circle, quadrangle, triangle and line) to form a silanol group in the irradiated area. In Figs. 1 to 4, dark areas represent the masked regions. The resulting pattern surface is shown in Table 5. Formation of the objective pattern was confirmed by a field emission scanning electron microscope (FE-SEM).

**Table 5**

| | Organic silane | Combination of pattern | Shape of pattern |
|---|---|---|---|
| Preparation Example 7 | Br-Rf1 | Br-Rf1/SiOH | circle |
| Preparation Example 8 | Br-Rf2 | Br-Rf2/SiOH | line |
| Preparation Example 9 | Br-Rf3 | Br-Rf3/SiOH | triangle |
| Preparation Example 10 | PFPE | PFPE/SiOH | line |
| Preparation Example 11 | Rf-Ac | Rf-Ac/SiOH | circle |
| Preparation Example 12 | Rf-Ur | Rf-Ur/SiOH | line |
| Preparation Example 13 | Rf-Es | Rf-Es/SiOH | triangle |
| Preparation Example 14 | Rf-Et | Rf-Et/SiOH | line |
| Preparation Example 15 | Rf-Am | Rf-Am/SiOH | circle |
| Preparation Example 16 | Rf-POSS1 | Rf-POSS1/SiOH | quadrangle |
| Preparation Example 17 | Rf-POSS2 | Rf-POSS2/SiOH | line |
| Comparative Preparation Example 5 | St-Rf | St-Rf/SiOH | line |

### Examples 7 to 17 and Comparative Example 5

Using each pattern surface shown in Table 5 as a template, a 1 wt% functional compound solution shown in Table 6 was applied thereon. Spin coating was performed at 2000 rpm, and dip coating was performed by pulling-up the pattern surface at a rate of 1 mm/second.

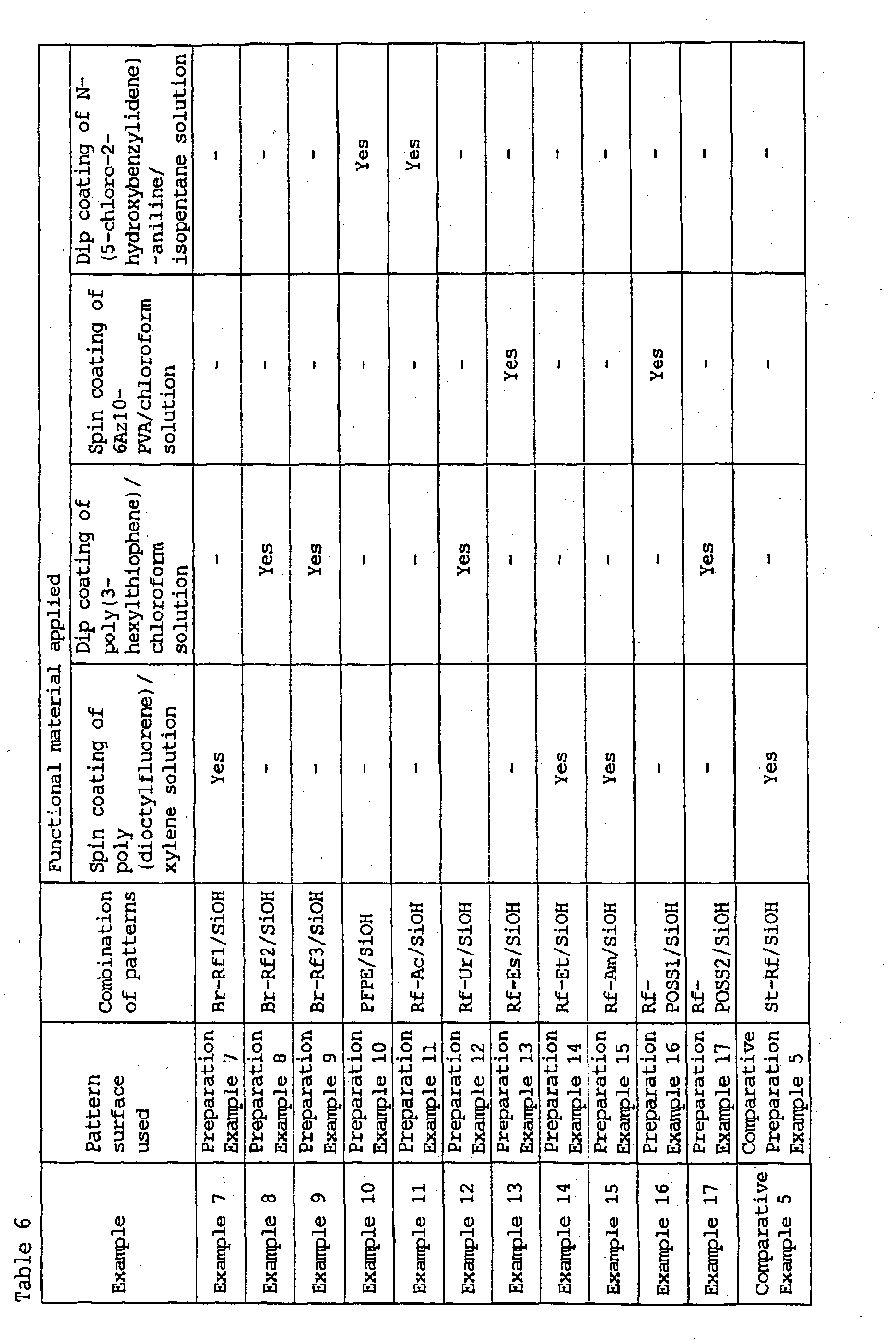

In Examples 7 to 17 of the present invention, it was confirmed by an optical microscope and an atomic force microscope that a thin film of a functional compound is formed in a shape, which is the same as that of the pattern surface, on the pattern surface used as the template (150 nm thick). The thin film was formed only in the SiOH region. In Comparative Example 5, a uniform thin film (140 nm thick) of the functional compound was formed on the entire surface of the substrate, regardless of the shape of the pattern surface.

### 4. Test Example in which Rf-POSS1 is used for one line pattern surface

### Example 18 and Comparative Example 6

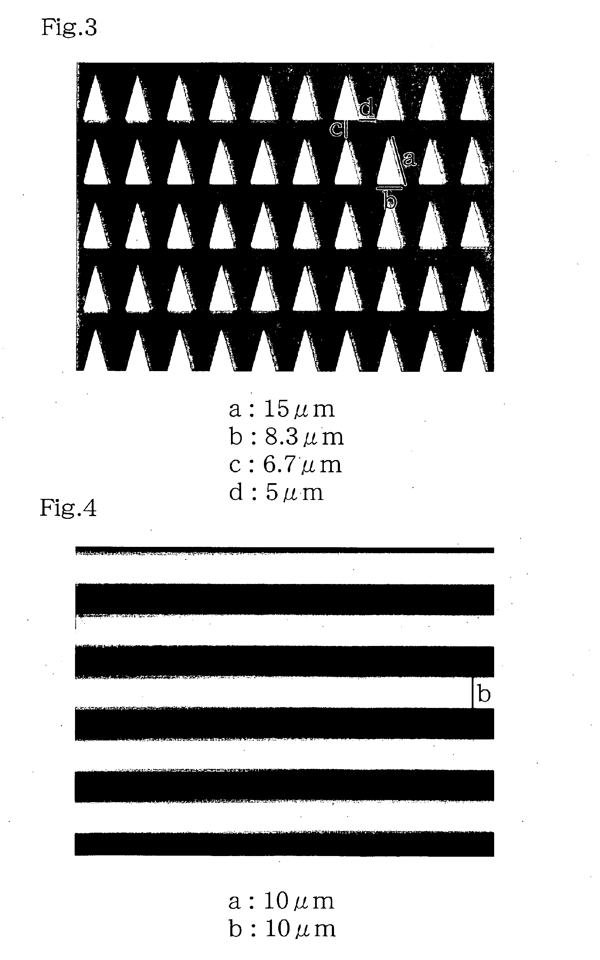

On the same silicon wafer as in Preparation Example 1, a fluorine organic silane Rf-POSS1 shown in Table 4 was chemically adsorbed in a liquid phase by the same method as in Preparation Example 7. Then, the silicon wafer was irradiated with vacuum-ultraviolet light (172 nm) through a line-shaped photomask shown in Fig. 4 to form a silanol group in the irradiated area. Formation of the objective pattern was confirmed by FE-SEM. In Example 18, a 1 wt% poly(3-hexylthiophene) solution was dropped on the pattern surface by using an ink-jet apparatus produced by us. Ink-jet conditions are as follows. That is, a microdroplet having a diameter of several tens of µm was prepared one by one by an on-demand system and then dropped at intervals of 1 mm. In Comparative Example 6, the microdroplet was dropped by the ink-jet apparatus on Rh(C10)/SO₃H having a line width of 10 µm (Comparative Preparation Example 2 shown in Table 2) in the same manner as in Example 18. The shape of the poly(3-hexylthiophene) thin film formed on the pattern surface was observed by an optical microscope. As a result, it has been found that a thin film was formed in a line shape, which is faithful to the line shape having a line width of 10 µm, was formed in Example 18. The thin film was formed only at the SiOH region. In Comparative Example 6, a circular thin film having a diameter of about 100 µm was formed, regardless of lines of the pattern surface.

### 5. Test Example in which a fluorine compound having a specific structure is used for one pattern surface with various shapes

### Example 19 and Comparative Example 7

On the same silicon wafer as in Preparation Example 1, a fluorine organic silane Rf-POSS1 shown in Table 4 was chemically adsorbed in a liquid phase in the same manner as in Preparation Example 7. Then, the silicon wafer was irradiated with vacuum-ultraviolet light (172 nm) through a line-shaped photomask shown in Fig. 4 to form a silanol group in the irradiated area. Formation of the objective pattern was confirmed by FE-SEM. In Example 19, using this pattern surface as a template, pentacene was vapor-deposited on the pattern surface (150 nm thick). In Comparative Example 7, pentacene was vapor-deposited on an untreated silicon wafer (160 nm thick). In both cases, pentacene was vapor-deposited at a substrate temperature of 200°C.

After placing a metal deposition mask on the substrate, source and drain electrodes of gold were formed on the substrate by a vacuum deposition method. The source and drain electrodes were disposed vertically to lines of the substrate. The thickness of the gold vapor-deposited film was set to 100 nm. A distance (channel length) L between the source and drain electrodes was set to 10 µm and the length (channel width) W of the source and drain electrodes was set to 10 mm. Then, an Al thin film for leading-out a gate electrode was vapor-deposited on the back surface of the silicon wafer to give an organic TFT comprising a pentacene vapor-deposited film.

Mobility was 0.13 cm²/Vs in case of using the pattern surface as the substrate, while mobility was 0.005 cm²/Vs in case of using the untreated silicon wafer as the substrate.

### EFFECT OF THE INVENTION

According to the present invention, an anisotropic material having an alternating-line pattern structure can be produced by a simple application (or coating) process.

In the present invention, a structure of a functional compound of nanometer to micrometer order can be produced by a simple application process.

In the present invention, properties of a functional compound can be improved by using, as a template, the surface of a pattern, at least one region of which is surface-treated with a fluorine compound having a specific structure.

## Claims

1. An anisotropic material comprising an alternating-line pattern and a layer of at least one functional compound selected from the group consisting of a semiconductor compound, an electrically conductive compound, a photochromic compound and a thermochromic compound, formed on a surface of the alternating-line pattern, wherein one type of lines in the alternating-line pattern surface comprises a fluorine-containing compound or silicone.

2. The anisotropic material according to claim 1, wherein a difference between surface free energy of the type of lines comprising the fluorine compound or silicone and surface free energy of the other type of lines is at least 5 mJ/m².

3. The anisotropic material according to claim 1, wherein the alternating-line pattern has a line width of 0.5 to 100 µm.

4. The anisotropic material according to claim 1, wherein the alternating-line pattern has unevenness of not more than 10 nm.

5. The anisotropic material according to claim 1, wherein the shape of droplets is distorted when 2 µL of ethanol is gently dropped from above the alternating-line pattern, and the degree of distortion is at least 1.1 in terms of a ratio L/W of the length in a major axis (L) to the length in a minor axis (W) of droplets.

6. The anisotropic material according to claim 1, wherein the alternating-line pattern comprises an organic silane compound, an organic thiol compound, an organic disulfide compound and/or an organic phosphoric acid ester.

7. A method for producing an anisotropic material, which comprises applying a solution of at least one functional compound selected from the group consisting of a semiconductor compound, an electrically conductive compound, a photochromic compound and a thermochromic compound on the surface of an alternating-line pattern, one type of lines of which comprises a fluorine-containing compound or silicone.

8. The method according to claim 7, wherein a liquid which dissolves the functional compound is a solvent having a surface tension of not more than 30 mN/m.

9. A method for producing a functional material, comprising using, as a template, a pattern surface composed of plural regions each having different surface free energy,
**characterized in that**:
(1) at least one region of the pattern surface is treated with a fluorine compound, and
(2) the method comprises applying a functional compound solution on the pattern surface and removing a solvent.

10. The method according to claim 9, wherein the fluorine compound comprises a fluorine compound having the following structure:
(a) a fluorine compound which has a branched fluoroalkyl group having 5 or less carbon atoms,
(b) a fluorine compound having a perfluoropolyether group,
(c) a fluorine compound having a polymer structure obtained by polymerizing a monomer which has a fluoroalkyl group having 5 or less carbon atoms,
(d) a fluorine compound having a linking group which is any one of an urethane group, an ester group, an ether group and an amide group, existing between a fluoroalkyl group having 5 or less carbon atoms and a functional group,
(e) an incompletely-condensed silsesquioxane which has a fluoroalkyl group having 5 or less carbon atoms, and/or
(f) a completely-condensed silsesquioxane which has a silane group and a fluoroalkyl group having 5 or less carbon atoms.

11. A functional material produced by the method according to claim 9.

12. A method for producing a functional material, which comprises applying a functional compound to a pattern surface having at least one region surface-treated with a fluorine compound.

13. The method according to claim 12, wherein the fluorine compound comprises a fluorine compound having the following structure:
(a) a fluorine compound which has a branched fluoroalkyl group having 5 or less carbon atoms,
(b) a fluorine compound having a perfluoropolyether group,
(c) a fluorine compound having a polymer structure obtained by polymerizing a monomer which has a fluoroalkyl group having 5 or less carbon atoms,
(d) a fluorine compound having a linking group which is any one of an urethane group, an ester group, an ether group and an amide group, existing between a fluoroalkyl group having 5 or less carbon atoms and a functional group,
(e) an incompletely-condensed silsesquioxane which has a fluoroalkyl group having 5 or less carbon atoms, and
(f) a completely-condensed silsesquioxane which has a silane group and a fluoroalkyl group having 5 or less carbon atoms.

14. A functional material produced by the method according to claim 12.
